# EUROPEAN PATENT APPLICATION

(11) **EP 1 914 792 A2**
(43) Date of publication of application: **23.04.2008**
(21) Application number: 07106107.1
(22) Date of filing: 13.04.2007
(51) Int. Cl.: H01L 21/02, H01L 21/768

(54) **Method of manufacturing a coil**

(30) Priority: 17.10.2006 KR 20060101043; 23.01.2007 KR 20070007239
(71) Applicant: Samsung Electronics Co., Ltd., Suwon-si Gyeonggi-do 443-742 (KR)
(72) Inventor: Jeong, Hyun-Ku, c/o Samsung Advanced Institute of Technology, Gyeonggi-do (KR); Kang, Seok-jin, c/o Samsung Advanced Institute of Technology, Gyeongg-do (KR); Chung, Seok-whan, c/o Samsung Advanced Institute of Technology, Gyeonggi-do (KR)
(74) Representative: Greene, Simon Kenneth

(57) **Abstract**

Provided is a method of manufacturing a coil for a micro-actuator. The method of manufacturing a coil for a micro-actuator includes the steps of preparing a substrate, forming a plurality of trenches for forming a coil on the substrate, covering portions on the substrate with a masking layer except for the plurality of trenches, electroplating the plurality of trenches with a conductive material, and forming a passivation layer on the substrate. According to the method, variations in sections of a coil can be reduced by minimizing bending and warp of a wafer, and therefore a driving current applied to a coil and power consumption can be reduced.

## Description

### BACKGROUND OF THE INVENTION

The present invention relates to a method of manufacturing a coil for an electromagnetic micro-actuator.

A scanner using electromagnetic effect is used as a micro-actuator for deflecting a laser beam in a large-size display apparatus and is comprised of at least a permanent magnet, a movable plate, a mirror provided at the movable plate for changing an optical path. A coil to which a current is applied is provided at the movable plate. Therefore, as an electric force produced by applying the current to the coil and a magnetic force produced by the magnetic interact, the movable plate is pivoted and the angle of the mirror is adjusted.

Such a coil is mass-produced by a method of forming a plurality of coils on a wafer using semiconductor processes. A coil is formed by the steps of: forming trenches on a substrate where the coil is to be formed, depositing metal on the trenches, and then removing the top surface of the substrate using a chemical-mechanical planarization (CMP) process.

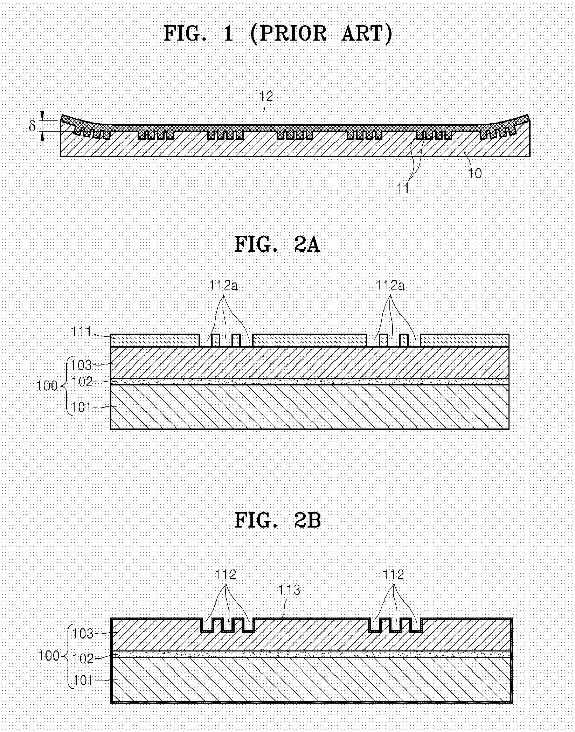

FIG. 1 is a cross-sectional view illustrating a wafer 10 on which after trenches are formed to form coils 11, conductive metal 12 is deposited according to a conventional art.

Referring to FIG. 1, in order to form a plurality of coils 11 on the wafer 10, trenches are formed on the wafer 10, and then the conductive metal 12 is deposited thereon. The wafer 10 experiences inevitable slight warp after a high-temperature processing, and when the conductive metal 12 is deposited on the wafer 10, an amount of warp δ occurs due to the weight of the conductive metal 12, as illustrated in FIG. 1.

Therefore, such deformation occurs at the middle of the wafer 10 and peripheral portions.

In this state, the conductive metal 12 deposited on the top surface of the wafer 10 is removed by the CMP process. At this time, due to the deformation of the wafer 10, not only the conductive metal 12 but also portions of coils are removed at the peripheral portions of the wafer.

Accordingly, sectional areas of the coils 11 formed at the peripheral portions of the wafer 10 are decreased, and the decrease of the sectional areas results in increase of a driving current of a micro-actuator. Consequently, power consumption of the micro-actuator is increased.

### SUMMARY OF THE INVENTION

The present invention provides a method of manufacturing a coil for an electromagnetic micro-actuator in which over-cutting of a coil can be reduced during a chemical-mechanical planarization (CMP) process by minimizing warp and deforming of a wafer when a coil is manufactured using semiconductor processes.

There is provided a method of manufacturing a coil for a micro-actuator includes the steps of preparing a substrate, forming a plurality of trenches for forming a coil on the substrate, covering portions on the substrate with a masking layer except for the plurality of trenches, electroplating the plurality of trenches with a conductive material, and forming a passivation layer on the substrate.

### BRIEF DESCRIPTION OF THE DRAWINGS

The above objective and advantages of the present invention will become more apparent by describing in detail preferred embodiments thereof with reference to the attached drawings in which:
FIG. 1 is a cross-sectional view illustrating a wafer on which after trenches are formed to form coils, conductive metal is deposited according to a conventional art.;
FIGS. 2A through 2E are cross-sectional views illustrating a method of manufacturing a coil for a micro-actuator according to the present invention; and
FIGS. 2F through 2K are cross-sectional views illustrating a method of manufacturing a micro-actuator using a coil manufactured according to the present invention.

### DETAILED DESCRIPTION OF THE INVENTION

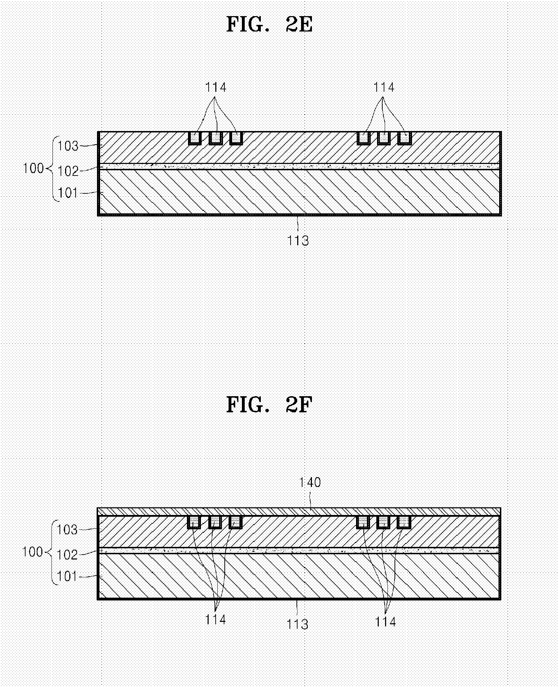

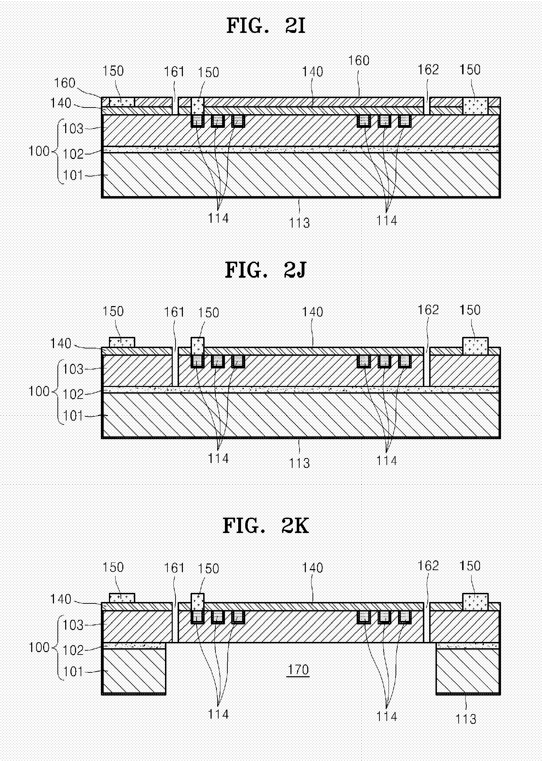

FIGS. 2A through 2E are cross-sectional views illustrating a method of manufacturing a coil for a micro-actuator according to the present invention. FIGS. 2F through 2K are cross-sectional views illustrating a method of manufacturing a micro-actuator using a coil manufactured according to the present invention. The methods of manufacturing the coil and the micro-actuator to be described below are performed using known processes of microelectromechnical systems (MEMS), and therefore detailed descriptions of well-known processes of the MEMS will be omitted.

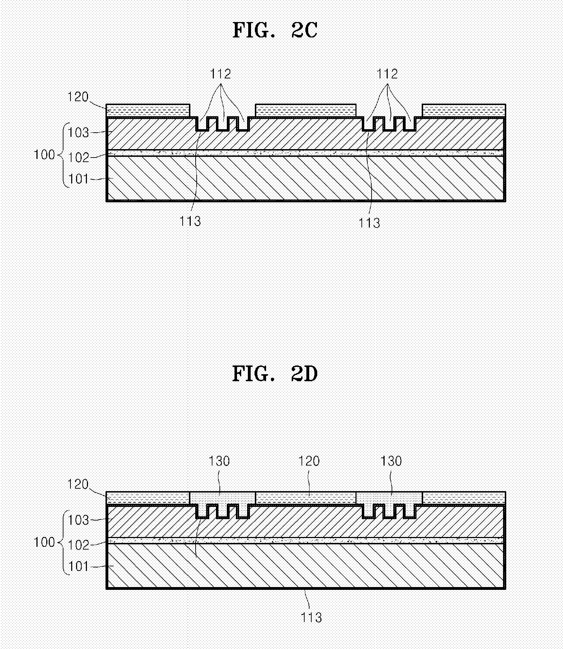

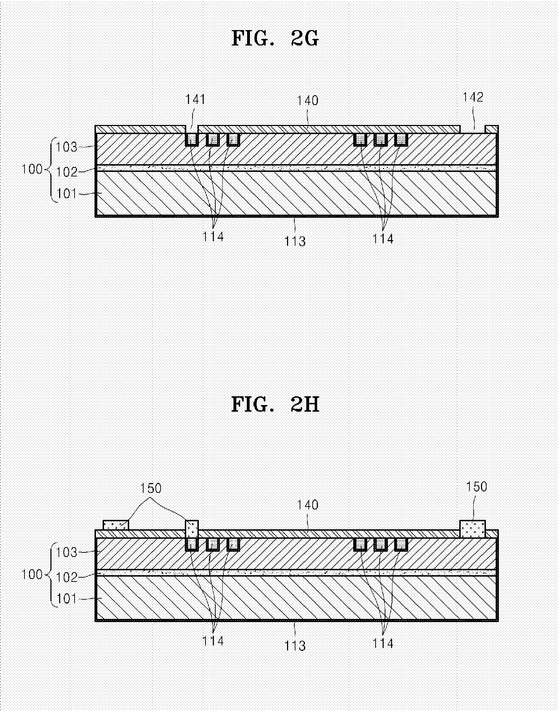

Referring to FIG. 2A, a substrate 100 is prepared, and a photo-mask 111 in which a plurality of patterns 112a is formed for forming a plurality of trenches 112 (please refer to FIG. 2) is also prepared. A silicon-on-insulator (SOI) wafer may be used as the substrate 100. The SOI wafer comprises a first silicon layer 101 which is a lower handle wafer made of silicon (Si), a second silicon layer 103 which an upper device wafer made of Si, and a sacrificial layer 102 which is a dielectric layer made of silicon oxide (SiO₂).

Referring to FIG. 2B, a plurality of trenches 112 is formed on the substrate 100 using a photo-mask in a photolithographic process. Then, a dielectric layer 113 is formed around the outer circumferential surface at a thickness of 1 µm using a thermal oxidation process. Therefore, the insides of the plurality of trenches are coated with the dielectric layer 113.

FIG. 2C and 2D illustrate processes according to a feature of the present invention. The feature of the present invention is that when the conductive metal 130 is electroplated onto the plurality of trenches 112, in order to prevent warp of the substrate 100 from occurring due to electroplating of the conductive metal 130 on areas of the substrate 100 other than the plurality of trenches 112, warp of the substrate 100 is minimized by reducing areas of the substrate 100 on which the conductive metal 130 is electroplated. To this end, a remaining area of the substrate 100 except for the plurality of trenches 112 on which the conductive metal 130 is to be electroplated is masked by a masking layer 120 so that the conductive metal 130 can be electroplated only on the plurality of trenches 112.

Referring FIG. 2C, the remaining area of the substrate 100 is masked by the masking layer 120 except for the plurality of trenches 112. The masking layer 120 is preferably a photoresist. Therefore, the plurality of trenches 112 is open, and the remaining area of the substrate 100 is blocked to the outside by the masking layer 120.

Referring to FIG. 2D, the conductive metal 130 is electroplated on portions not covered by the masking layer 120. Then, the plurality of trenches 112 is electroplated by, and filled with the conductive metal 130. That is, the conductive metal 130 is not electroplated on the masking layer 120, but is electroplated only on the plurality of trenches 112. The conductive metal 130 may be titanium (Ti), chromium (Cr), or copper (Cu).

Furthermore, in the step of FIG. 2D, the conductive metal 130 is vaporized and deposited on the plurality of trenches 112 and the masking layer 120. Then, when the masking layer 120 is etched, the conductive metal 130 on the masking layer 120 is lift off and removed. Consequently, the conductive metal 130 covers only over the plurality of trenches 112. Thereafter, the conductive metal 130 covering the plurality of trenches 112 can be removed by the CMP process.

On the other hand, in order to prevent the substrate 100 from bending or deforming, a Damascene process may be utilized. Since the Damascene process is a difficult process, the bending and deforming of the substrate 100 can be prevented effectively by using the method of masking the other portions of the substrate 100 than the portions of the plurality of trenches 112 as described in the present invention. As a matter of course, the masking layer 120 of the present invention may be used together with the Damascene process.

Referring to FIG. 2E, the masking layer 120 and the conductive metal 130 which are formed on the upper surface of the substrate 100 are removed by using a chemical mechanical planarization (CMP). At this time, the dielectric layer 113 formed on the upper surface of the substrate 100 is removed too. Subsequently, a plurality of coils 114 is formed on the substrate 100.

Referring to FIG. 2F, a passivation layer 140 for insulation is deposited on the substrate 100 on which the plurality of coils 114 is formed. The passivation layer 140 is deposited by using a plasma-enhanced chemical vapor deposition (PECVD) method.

Referring to FIG. 2G, pattern portions 141 and 142 for forming an electrode pad and a sensing pad are formed by patterning the passivation layer 140 using the photolithographic process.

Referring to FIG. 2H, the conductive metal 150 is sputtered to the pattern portions 141 and 142 for forming the electrode pad and the sensing pad. The conductive metal may be chromium (Cr) or gold (Au). The chromium (Cr) can be deposited in a thickness of 700 Å, and the gold (Au) can be deposited in a thickness of 1 µm by using the sputtering method.

After depositing the chromium (Cr) or the gold (Au) to the patterning portions 141 and 142, the deposited chromium (Cr) or gold (Au) is patterned by using the photolithographic process and etching. In the case of the chromium (Cr), dry etching is used, and in the case of the gold (Au), wet etching is used.

Referring to FIG. 21, a photoresist 160 is deposited on the passivation layer 140, and then holes 161 and 162 for forming combs are patterned by etching and removing portions of the photoresist 160 and the passivation layer 140 to the upper surface of the substrate 100.

Referring to FIG. 2J, a portion of the second silicon layer 103 is etched to the sacrificial layer 102 of the substrate 100 and removed. Then, the photoresist 160 is removed. Consequently, the holes for forming the combs pass through the passivation layer 140 and the second silicon layer 103.

Referring to FIG. 2K, the first silicon layer 101 of the substrate 100 is etched to form a space 170. At this time, a portion of the sacrificial layer 102 is removed, and the holes 161 and 162 communicate with the space 170 and pass through the substrate 100.

As described above, in the method of manufacturing a coil for a micro-actuator according to the present invention, since the plurality of trenches forming a coil is opened, and a conductive material masks the other areas except for the trenches, bending and warp of a wafer is minimized and variations in sections of a coil can be reduced. Thus, driving current applied to the coil and power consumption of the coil can be reduced. In addition, since thickness of a spring of a driving portion is defined by variation of thickness in the CMP process, there is an effect of minimizing occurrence of differences in frequency in one wafer.

## Claims

1. A method of manufacturing a coil for a micro-actuator including the steps of:
(a) preparing a substrate;
(b) forming a plurality of trenches for forming a coil on the substrate;
(c) covering portions on the substrate with a masking layer except for the plurality of trenches;
(d) electroplating the plurality of trenches with a conductive material; and
(e) forming a passivation layer on the substrate.

2. The method of claim 1, wherein, in the step (c), the masking layer is a photoresist.

3. The method of claim 1 or 2, wherein, in the step (d), the conductive material is not electroplated on the areas masked by the masking layer, and is electroplated only on the other areas not masked by the masking layer.

4. The method of claim 1, 2 or 3, wherein, after the step (d), a step of removing the masking layer and the conductive material is further included.

5. The method of any preceding claim, wherein, in the step (b), the outer circumferential surfaces are coated with a dielectric layer using a thermal oxidation process.

6. The method of any preceding claim, wherein, in the step (b), the plurality of trenches is formed using a photomask.

7. The method of any preceding claim, wherein, in the step (a), the substrate is a silicon-on-insulator (SOI) wafer.
